# FASCICULE DE BREVET EUROPEEN

(11) **EP 3 551 501 B1**
(45) Date de publication et mention de la délivrance du brevet: **05.04.2023**
(21) Numéro de dépôt: 17825140.1
(22) Date de dépôt: 07.12.2017
(51) Int. Cl.: B60R 11/02, H05K 7/20

(54) **DISPOSITIF DE DISSIPATION DE CHALEUR D'UNE UNITE DE CONTROLE MULTIMEDIA**
WÄRMEABLEITUNGSVORRICHTUNG FÜR EINE MULTIMEDIA-STEUEREINHEIT
HEAT DISSIPATION DEVICE FOR A MULTIMEDIA CONTROL UNIT

(30) Priorité: 12.12.2016 FR 1662311
(43) Date de publication de la demande: 16.10.2019
(73) Titulaire: Aptiv Technologies Limited, St. Michael (BB)
(72) Inventeur: SZOSTEK, Grzegorz, 32-084 Morawica (PL); HYRLICKI, Marcin, 32-060 Liszki (PL); ADAMCZYK, Krzysztof, 32-731 Zegocina (PL); BRACHE, Pawel, 31-589 Krakow (PL)
(74) Mandataire: Vigand, Philippe
(86) Numéro de dépôt international: PCT/EP2017/081882
(87) Numéro de publication internationale: WO 2018/108702

(56) Documents cités:
- EP-A1- 1 885 169
- US-A1- 2006 139 878
- US-B1- 6 466 441

## Description

### DOMAINE TECHNIQUE

L'invention concerne le domaine des unités de contrôle électronique multimédia automobile. Plus particulièrement, l'invention concerne un dispositif de dissipation de chaleur pour une unité de contrôle électronique multimédia.

### ARRIERE-PLAN TECHNOLOGIQUE DE L'INVENTION

Les unités de contrôles multimédia électroniques embarquées dans l'automobile comprennent généralement un boîtier métallique pourvu de nombreux connecteurs d'interface électronique. Le boîtier métallique comprend généralement des modules électroniques agencés dans des racks métalliques disposés parallèlement les uns à côté des autres. Chaque module électronique est généralement dédié à une fonction multimédia telle que la compression ou décompression du son, la compression ou décompression de films vidéo, l'amplification du son, la réception et le traitement des signaux d'un système de navigation, la réception et la démodulation de signaux de radio, d'interface de communication sans fils entre le véhicule et des équipement portatifs, d'interface de téléphonie...

Chaque rack métallique a une structure métallique comprenant de fines ailettes afin de servir de dispositif de dissipation de chaleur à leur module électronique respectif. Le boîtier métallique comprend également généralement des ouvertures permettant d'évacuer la chaleur dissipée par les racks métalliques. Il est également connu de faciliter l'extraction de l'air chaud des modules électroniques à l'aide d'un ventilateur agencé dans le boîtier métallique et en vis à vis d'ouvertures du boîtier métallique. La structure métallique permet également de répondre aux contraintes d'interférences électromagnétiques entre les modules électroniques et également aux contraintes des interférences radio fréquences externes à l'unité de contrôle multimédia.

Les unités de contrôles multimédia connues sont donc volumineuses, lourdes et complexes à assembler. Leur structure actuelle ne répond pas aux exigences actuelles de réduction de poids et également de volume pour les véhicules actuels et à venir.

Il est donc important de proposer une solution nouvelle résolvant ces problèmes.

EP 1885169 A1 divulgue un dispositif de refroidissement par air pour appareil électronique; US6466641 B1 divulgue um dispositif de refroidissement d'une partie électronique agencée dans un serveur PC ou un serveur UNIX ; US2016/139878 A1 divulgue des ensembles dissipateur thermique et support de composants.

### RESUME DE L'INVENTION

Un dispositif de dissipation de chaleur comprend un plateau métallique de refroidissement globalement rectangulaire, le plateau métallique comprenant sur sa face supérieure des premiers moyens de fixation d'une première carte à circuit imprimé prévus pour mettre en appui au moins une zone génératrice de chaleur de la première carte à circuit imprimé sur la face supérieure du plateau. Le plateau métallique comprend sur sa face inférieure des second moyens de fixations d'une seconde carte à circuit imprimé prévus pour mettre en appui au moins une zone génératrice de chaleur de la seconde carte à circuit imprimé sur la face inférieure du plateau.

La face supérieure du plateau peut comprendre une première section équipée d'une pluralité d'ailettes verticales de refroidissement s'étendant chacune selon une direction longitudinal sensiblement parallèle à un côté du plateau; la première section comprenant une partie des premiers moyens de fixation de sorte à permettre l'appui d'une zone génératrice de chaleur de la première carte à circuit imprimé sur des ailettes de refroidissement. La face inférieure de la première section peut comprendre au moins une surface plane de refroidissement formant une protubérance sur la dite face inférieure, de sorte à permettre l'appui d'une zone génératrice de chaleur de la seconde carte à circuit imprimé sur la surface plane de refroidissement. La première section peut comprendre une zone plane de refroidissement s'étendant transversalement sur le haut d'au moins deux ailettes de sorte à permettre l'appui d'une zone génératrice de chaleur de la première carte à circuit imprimé sur la zone plane de refroidissement. La première section peut comprendre au moins un plot cylindrique plein vertical surmoulé dans une ailette de refroidissement de sorte à permettre l'appui d'une zone génératrice de chaleur de la première carte à circuit imprimé sur l'extrémité libre du plot cylindrique plein. La première section forme un renfoncement rectangulaire dans la face supérieure du plateau, formant une protubérance rectangulaire sur la face inférieure du plateau.

La face inférieure de la première section peut comprendre une partie des seconds moyens de fixation de sorte à permettre l'appui d'au moins une zone génératrice de chaleur de la seconde carte à circuit imprimé sur la face inférieure de la première section..

Le plateau peut comporter au moins trois piliers métalliques s'étendant verticalement vers le bas depuis la face inférieure du plateau. L'extrémité basse de chaque pilier peut être munie d'un moyen de fixation prévu pour être fixé sur un fond de boîtier de sorte à maintenir le plateau surélevé pour agencer la seconde carte à circuit imprimé sur la face inférieure du plateau. Un côté transversal du plateau peut comporter un support de ventilateur apte à recevoir un ventilateur permettant de créer un flux d'air de refroidissement du plateau suivant une direction longitudinale. Le plateau peut comporter des déflecteurs agencés entre le support de ventilateur et la première section apte à guider le flux d'air de refroidissement. Le plateau peut comporter une ouverture entre la première section et le support de ventilateur, de sorte à favoriser un flux d'air sur les deux faces du plateau.

Le plateau peut comprendre un élément de liaison électrique comprenant deux extrémités de contact flexibles, la première extrémité étant prévue pour établir un contact électrique par compression entre le plateau de refroidissement et un élément électriquement conducteur de la première carte à circuit imprimé ou de la seconde carte à circuit imprimé; la seconde extrémité étant prévue pour établir un contact électrique par compression entre le plateau et un boîtier métallique enfermant le dispositif de dissipation de chaleur; de sorte à protéger thermiquement et électromagnétiquement l'élément électriquement conducteur. L'élément de liaison électrique peut comprendre une partie intermédiaire par laquelle l'élément de liaison est fixé sur le plateau, la partie intermédiaire étant prolongée d'un côté par la première extrémité flexible suivant principalement une direction perpendiculaire au plateau, et de l'autre côté par la seconde extrémité flexible suivant principalement une direction coplanaire au plateau. Le dispositif de dissipation de chaleur peut être fait d'une seule pièce métallique.

Selon l'invention, un assemblage électronique comporte le dispositif de dissipation de chaleur décrit ci-dessus, une première carte à circuit imprimé globalement rectangulaire comportant une zone génératrice de chaleur en appui sur la face supérieure du plateau de refroidissement; une seconde carte à circuit imprimé globalement rectangulaire comportant une zone génératrice de chaleur en appui sur la face inférieure du plateau de refroidissement.

L'assemblage électronique peut comporter un boîtier métallique fermé de forme globalement parallélépipédique rectangle; le dispositif de dissipation de chaleur étant fixé dans le fond du boîtier. Le boîtier peut comprendre un premier groupe d'ouvertures agencé sur une première face latérale du boîtier et en vis-à-vis du plateau de refroidissement. Le boîtier peut également comprendre un second groupe d'ouvertures agencé sur une seconde face latérale du boîtier opposée à la première face et en vis-à-vis du plateau de refroidissement de sorte à permettre la circulation d'un flux d'air de refroidissement depuis le premier groupe d'ouvertures jusqu'au second groupe d'ouvertures. Un ventilateur peut être monté dans le support de ventilateur et peut être agencé dans le boîtier en vis-à-vis de l'un des deux groupes d'ouverture de sorte à faciliter la circulation du flux d'air de refroidissement. Le plateau peut comporter un élément de liaison électrique. Au moins une des cartes à circuit imprimé comprend un élément conducteur, l'élément conducteur étant en contact électrique par l'élément de liaison électrique avec le plateau et le boîtier métallique de sorte à protéger thermiquement et électromagnétiquement l'élément conducteur.

### BREVE DESCRIPTION DES DESSINS

D'autres caractéristiques, buts et avantages de l'invention apparaîtront à la lecture de la description détaillée qui va suivre, et en regard des dessins annexés, donnés à titre d'exemple non limitatif et sur lesquels:
- La figure 1 et la figure 2 sont des vues schématique en perspective de l'unité de contrôle multimédia selon l'invention.
- La figure 3 représente une vue schématique éclatée en perspective de l'unité de contrôle multimédia selon l'invention.
- La figure 4 représente une vue schématique en perspective de la face supérieure du dispositif de dissipation de chaleur de l'unité de contrôle multimédia selon l'invention.
- La figure 5 représente une vue schématique en perspective de l'assemblage d'une première carte à circuit imprimé sur la face supérieure du dispositif de dissipation de chaleur de l'unité de contrôle multimédia selon l'invention.
- La figure 6 représente une vue schématique en perspective de la face inférieure du dispositif de dissipation de chaleur de l'unité de contrôle multimédia selon l'invention.
- La figure 7 représente une vue schématique en perspective de l'assemblage d'une seconde carte à circuit imprimé sur la face inférieure du dispositif de dissipation de chaleur de l'unité de contrôle multimédia selon l'invention.

### DESCRIPTION DES MODES DE REALISATION PREFERES

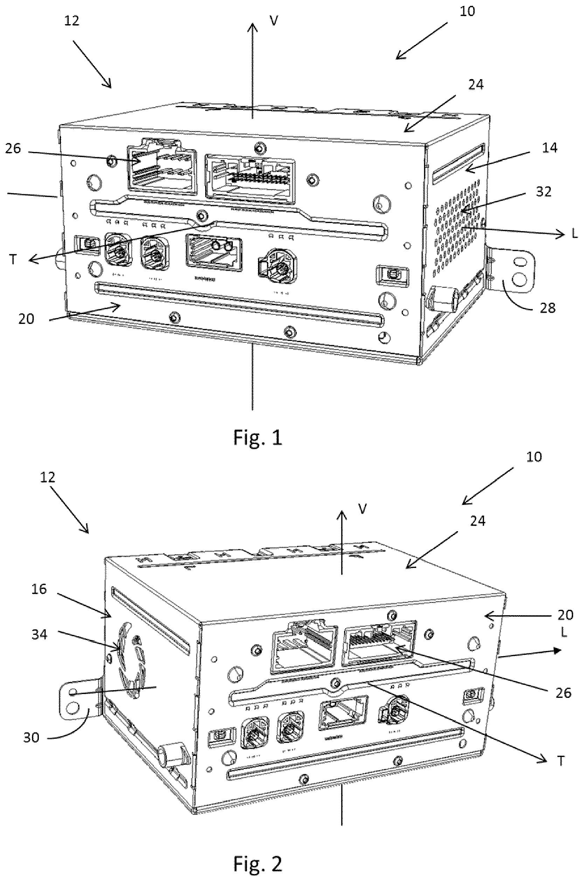

Selon la figure 1, la figure 2 et la figure 3, un exemple de mode de réalisation d'une unité de contrôle multimédia électronique 10 prévu pour être monté dans un véhicule automobile est représenté. L'unité de contrôle multimédia 10 comporte un boîtier métallique 12 formant globalement un parallélépipède rectangle. Le boîtier 12 de l'unité de contrôle 10 comporte donc six façades rectangulaires.

Afin de faciliter la description, et de façon non limitative, un repère orthogonal comprenant un axe longitudinal L, un axe transversal T et un axe vertical V est défini. Des orientations « bas », « haut », « dessus », « dessous », « inférieure » et « supérieure » sont définies selon la direction verticale. Des orientations « gauche », « droite » et « latérale » sont définies selon la direction de longitudinale. Des orientations « avant » et « arrière » sont également définies selon la direction transversale.

Le boîtier 12 comporte donc, selon la direction de l'axe longitudinal L, une façade latérale droite 14 et une façade latérale gauche 16. Le boîtier comporte également, selon la direction de l'axe transversal T, une façade arrière 18 et une façade avant 20. Enfin, le boîtier comprend selon la direction de l'axe vertical V, une façade inférieure 22 et une façade supérieure 24. La façade inférieure 22 du boîtier est également dénommée fond de boîtier.

La façade avant 20 et la façade arrière 18 comportent de multiples connecteurs 26 permettant à l'unité de contrôle multimédia 10 d'être connectée électriquement à d'autres équipements électroniques du véhicule. La façade arrière 18 comporte de part et d'autre selon l'axe longitudinal, deux oreilles de fixation 28, 30 permettant de monter l'unité de contrôle multimédia 10 dans le véhicule, plus précisément de la monter sur la carrosserie du véhicule servant de masse électrique du véhicule.

La façade latérale droite 14 et la façade latérale gauche 16 comportent respectivement un premier groupe d'ouvertures 32 et un second groupe d'ouvertures 34 prévues pour faire circuler dans l'unité de contrôle multimédia 10 un flux d'air. Plus particulièrement, la façade latérale gauche 16 est pourvue d'ouvertures 34 disposée globalement en cercle.

Le second groupe d'ouverture 34 est prévue pour faire sortir l'air chaud de l'unité de contrôle 10. De préférence un ventilateur 36 est disposé dans l'unité de contrôle 10 pour améliorer le flux d'air et plus particulièrement pour favoriser l'extraction de l'air chaud. Les pales de la roue à aubes du ventilateur 36 sont agencées directement en vis-à-vis du second groupe d'ouverture 34.

Le premier groupe d'ouverture 32 est prévue pour faire entrer de l'air frais dans l'unité de contrôle 10 à des fins de refroidissement.

La façade supérieure 24, conjointement avec les cinq autres façades 14, 16, 18, 20, 22, ferme le boîtier métallique 12, permettant au boîtier 12 de s'apparenter à une cage de protection aux interférences électromagnétiques externes.

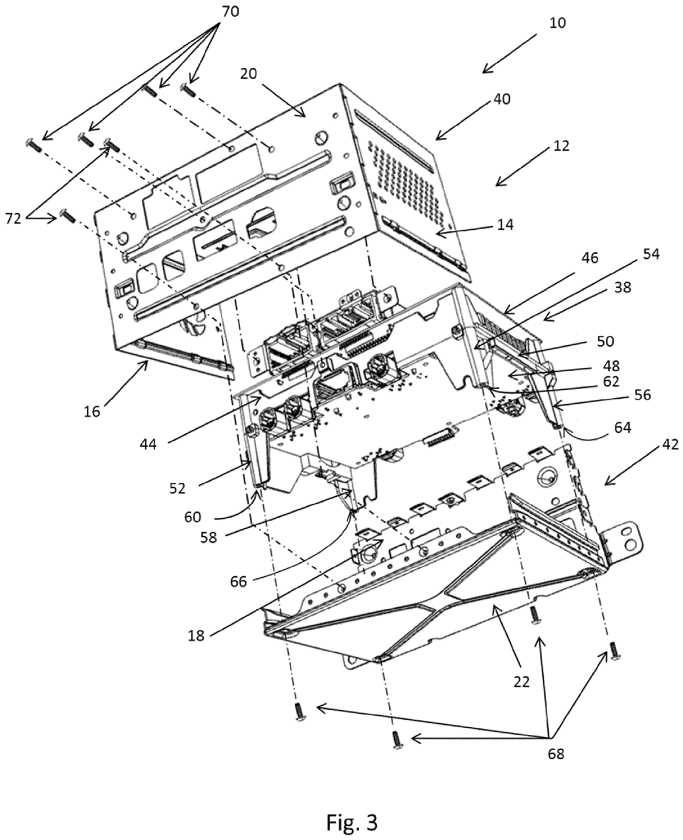

Selon la figure 3, l'unité de contrôle multimédia 10 électronique comprend le boîtier 12 et un sous ensemble électronique 38.

Le boîtier 12 est constitué d'une première pièce métallique 40 et d'une seconde pièce métallique 42. La première pièce métallique 40, faite d'une seule pièce, rassemble la façade supérieure 24, la façade avant 20, la façade latérale droite 14 et la façade latérale gauche 16. La seconde pièce métallique 42, faite d'une seule pièce, rassemble la façade inférieure 22 et la façade arrière 18.

Le sous ensemble électronique 38 comporte un dispositif de dissipation de chaleur 44 métallique sur lequel sont fixées une première carte à circuit imprimé 46 et une seconde carte à circuit imprimé 48.

La première carte à circuit imprimé 46 est fixée sur le dessus du dispositif de dissipation de chaleur 44. La seconde carte à circuit imprimé 48 est fixée sur le dessous du dispositif de dissipation de chaleur 44.

Le dispositif de dissipation de chaleur 44 comporte un plateau métallique 50 supporté par 4 piliers verticaux 52, 54, 56, 58 orientés vers le fond de boîtier 22 et dont chaque extrémité libre 60, 62, 64 ,66 est munie d'un pas de vis. Le plateau métallique 50 est agencé entre les deux cartes à circuit imprimé 46, 48.

A des fins d'assemblage de l'unité de contrôle multimédia 10, le boîtier 12 et le sous ensemble électronique 38 sont fixés ensemble par vissage. On notera plus particulièrement que la façade inférieure 22 du boîtier comporte à chacun de ses angles, des trous par lesquels des premières vis de fixation 68 viennent s'insérer dans les pas de vis des quatre piliers 52, 54, 56, 58 assurant ainsi le maintien du sous ensemble électronique 38 dans le boîtier 12. D'autres vis de fixation viennent fixer les autres façades au sous ensemble électronique 38. Plus particulièrement, on notera que des secondes vis de fixation 70, notamment sur la façade avant 20, viennent fixer la première pièce métallique 40 du boîtier à des corps métalliques de connecteur des cartes à circuits imprimé 46, 48. Enfin, des troisièmes vis de fixation 72 viennent fixer la première pièce métallique 40 du boîtier à la seconde pièce métallique 42 du boîtier.

Cet assemblage, par la mise en contact des pièces métalliques du sous ensemble électronique 38 avec le boîtier métallique 12, permet non seulement d'atteindre un premier niveau de dissipation de chaleur, et également d'atteindre un premier niveau de protection du sous ensemble électronique contre les interférences électromagnétiques.

D'autres vis de fixations permettant l'assemblage du boîtier avec le sous ensemble électronique 38 sont possibles. A titre d'exemple et de façon non limitative, la façade arrière peut également comporter un groupe de vis de fixation permettant de relier le boîtier 12 à d'autres corps métallique de connecteur des cartes à circuit imprimé.

Alternativement, le dispositif de dissipation de chaleur 44 peut comporter trois piliers ou plus, l'objectif étant de maintenir le plateau 50 surélevé au regard du fond de boîtier 22, permettant ainsi la fixation de la seconde carte à circuit imprimé 48.

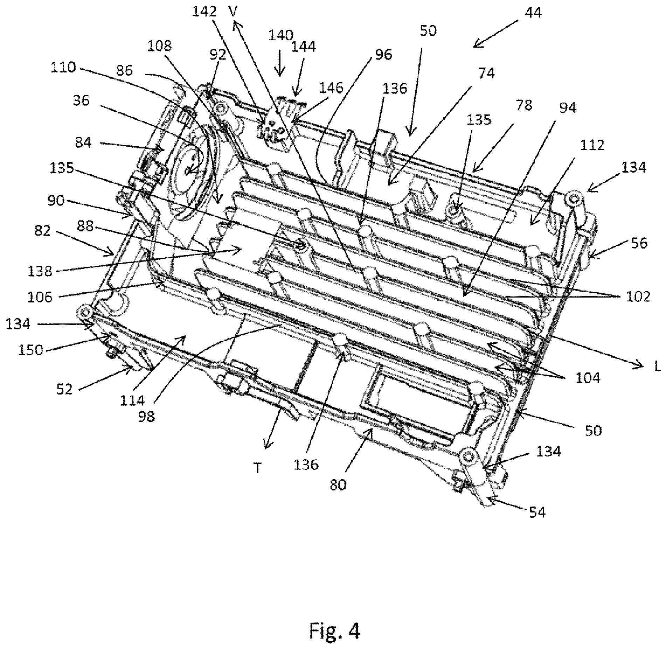

Selon la figure 4, le plateau métallique 50 est globalement horizontal selon le plan défini par l'axe longitudinal L et l'axe transversal T. Le plateau 50 est agencé sur les quatre piliers verticaux 52, 54, 56, 58. Le plateau 50 est globalement rectangulaire et présente un encombrement plan horizontal globalement similaire à la façade inférieure 22 du boîtier. Le plateau 50 comporte une face supérieure 74 orientée vers la façade supérieure 24 du boîtier et une face inférieure 76 orientée vers la façade inférieure 22 du boîtier. Le plateau 50 comporte, sur sa face supérieure 74, deux murets verticaux 78, 80 s'étendant chacun tout le long de ses deux côtés longitudinaux. La face supérieure 74 du plateau comporte également un muret vertical gauche 82 s'étendant le long de son côté gauche depuis le côté longitudinal avant jusqu'à une extrémité agencée approximativement à mi longueur du côté gauche. Un support de ventilateur 84 est agencé transversalement entre l'extrémité du muret vertical gauche 82 et le muret vertical arrière 78.

Le support de ventilateur 84 est agencé en continuité avec le muret vertical gauche 82. Le support de ventilateur 84 s'étend depuis l'extrémité du muret vertical gauche 82 jusqu'au muret vertical arrière 78. Le support de ventilateur 84 est agencé selon un plan vertical perpendiculaire à l'axe longitudinal L.

Le support de ventilateur 84 est de forme globalement rectangulaire. Le support comporte deux arêtes transversales 86, 88 et deux arêtes verticales 90, 92. Les deux arêtes verticales 90, 92 sont, l'une directement au contact avec l'extrémité du muret vertical gauche 82 et l'autre directement au contact du muret vertical arrière 78. Les deux arêtes transversales 86, 88 sont respectivement agencées l'une à une hauteur vertical au-dessus du plateau 50, l'autre à une hauteur vertical en dessous du plateau 50. De préférence, les deux arêtes 86, 88 transversales sont agencées à égale distance au-dessus et en dessous du plateau 50. Le support de ventilateur 84 présente en son centre une ouverture circulaire de diamètre quasi identique au diamètre de la roue à aubes d'un ventilateur 36, permettant à un ventilateur 36 agencé dans le support 84 de ventiler aussi bien la face supérieure du plateau 74 que la face inférieure du plateau 76.

La face supérieure du plateau 74 comporte une première section 94 plane horizontale de forme rectangulaire. La première section 94 est délimitée par deux bordures longitudinales parallèles aux côtés arrière et avant du plateau. Les deux bordures longitudinales forment chacune respectivement une paroi verticale arrière longitudinale 96 et une paroi verticale avant longitudinale 98. La première section 94 est centrée symétriquement selon l'axe de symétrie longitudinale L du plateau. La première section 94 s'étend longitudinalement depuis le côté droit transversal du plateau 50 jusqu'à approximativement les 4/5 de la longueur du plateau selon l'axe longitudinal. La première section 94 s'étend également transversalement, symétriquement de part et d'autre de l'axe de symétrie longitudinal L du plateau 50 jusqu'à une largeur totale selon l'axe transversal T représentant les 3/5 de la largeur du plateau.

La première section 94 forme un renfoncement rectangulaire dans la face supérieure du plateau, formant également une protubérance rectangulaire 100 sur la face inférieure du plateau 76.

La première section 94 comprend une pluralité d'ailettes 102 de refroidissement verticales dirigées vers le haut et s'étendant chacune selon l'axe longitudinal L sur toute la longueur de la première section 94. Les ailettes 102 sont régulièrement espacées les unes des autres par des espaces inter ailettes 104. La pluralité d'ailettes 102 est donc agencée entre la paroi verticale arrière longitudinale 96 et la paroi verticale avant longitudinale 98 de la première section 94. Chaque ailette est parallèle aux parois longitudinales de la première section 94. Les parois verticales 96, 98 longitudinales sont assimilables à des ailettes de refroidissement.

La paroi verticale arrière 96 et la paroi verticale avant 98 de la première section 94 sont reliées au support de ventilateur 84 par deux parois additionnelles 106, 108. Les deux parois additionnelles 106, 108 relient respectivement les deux parois verticales 96, 98 aux deux arêtes verticales 90, 92 du support de ventilateur 84.

Les deux parois additionnelles 106, 108 sont assimilables à deux déflecteurs permettant d'orienter avantageusement le flux d'air au travers des espaces inter ailettes de la première section 94. L'espace entre les deux parois additionnelles est une ouverture béante 110. L'ouverture béante entre la première section 94 et le support de ventilateur 84 permet de favoriser également le flux d'air aussi bien sur la face inférieure du plateau 76 que sur la face supérieure du plateau74.

La face supérieure du plateau 74 comporte, en dehors de la première section 94 et de chaque côté des deux parois 96, 98 de la première section 94, respectivement une seconde section 112 et une troisième section 114. La seconde section 112 et la troisième section 114 sont globalement des surfaces planes rectangulaires. La seconde section 112 est la section directement adjacente à la paroi verticale arrière longitudinale 96 de la première section 94. La troisième section 114 est la section directement adjacente à la paroi verticale avant longitudinale 98.

La seconde section 112 et la troisième section 114 s'étendent longitudinalement de part et d'autre de la première section 94, depuis le côté latéral droit du plateau 50 jusqu'au côté latéral gauche du plateau 50. La seconde section 112 et la troisième section 114 s'étendent également transversalement respectivement depuis chaque paroi verticale longitudinale de la première section 96, 98 jusqu'au muret vertical arrière 78 et jusqu'au muret vertical avant 80 du plateau 50. La seconde 112 et la troisième section 114 sont légèrement surélevées verticalement par rapport à la première section 94.

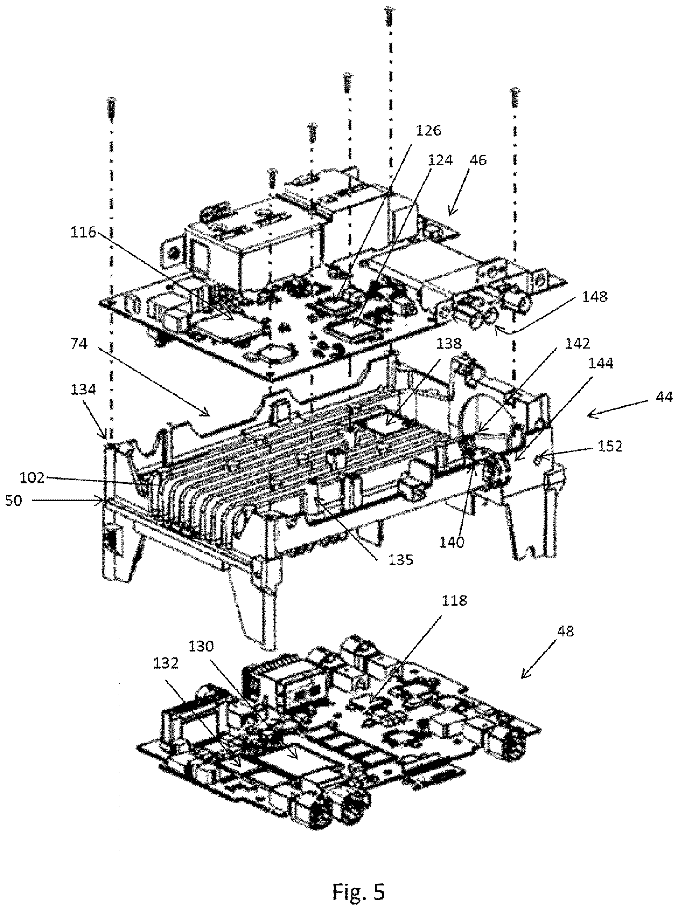

Selon la figure 4 et la figure 5, la première carte à circuit imprimé 46 et la seconde carte à circuit imprimé 48 comportent aussi bien sur leur face de dessus, que sur leur face de dessous des composants électroniques 116, 118, 120, 122 reliées entre eux par de pistes conductrices. Certains composants ou certaines pistes conductrices, notamment les pistes conductrices de forts courants, peuvent former des zones génératrices de chaleur 124, 126, 128, 130, 132, c'est-à-dire des zones générant de la chaleur lors du fonctionnement du module de l'unité de contrôle multimédia 10.

La face supérieure du plateau 74 est adaptée pour recevoir la première carte à circuit imprimé 46. La face supérieure du plateau 74 est équipée de plusieurs plots de fixation 134, 135 pour la première carte à circuit imprimé 46. Les plots de fixation 134, 135 prévus pour la première carte à circuit imprimé 46 sont orientés verticalement vers le haut et permettent le maintien à plat, selon un plan horizontal, de la première carte à circuit imprimé 46. Tous les plots de fixations 134, 135 sont de forme cylindrique creuse, le creux étant un pas de vis. La première carte à circuit imprimé 46 est donc prévue pour être en appui par vissage contre la pluralité d'ailettes 102 de la première section 94.

Selon le mode de réalisation représenté, à titre d'exemple et de façon non limitative, les plots de fixations 134 sont répartis sur la face supérieure 74 du plateau 50. Un premier plot de fixation 134 est agencé en bout de seconde section, à proximité directe du support de ventilateur et à proximité directe d'un premier angle du plateau. Un second 134, un troisième 134 et un quatrième plot de fixation 134 sont globalement agencés alignés verticalement avec les trois piliers verticaux de fixation du dispositif de dissipation de chaleur 44 disposés aux trois autres angles du plateau. Un cinquième plot de fixation 135 est agencé verticalement dans l'ailette agencée le long de l'axe de symétrie longitudinal du plateau. Le cinquième plot est globalement agencé au 2/3 de la longueur de la dite ailette. Enfin un sixième plot de fixation 135 est agencé adjacent à la paroi arrière de la première section, sur la seconde section 112, globalement au 1/3 de longueur de la première section.

Plus généralement, on notera que quatre plots de fixations 134 sont globalement prévus pour maintenir la première carte à circuit imprimé 46 à ces quatre angles. Deux autres plots de fixation 135 sont agencés sur les ailettes de refroidissement 102, à proximité des zones génératrices de chaleur 124, 126, 128 de la première carte à circuit imprimé 46 de sorte à améliorer l'appui de ces zones génératrices de chaleur 124, 126, 128 sur les ailettes de refroidissement 102.

Afin de faciliter la dissipation de chaleur de la première carte à circuit imprimé 46, la face supérieure de la première section 94 comporte des plots plein 136, dont l'extrémité libre supérieure sert de surface d'appui pour des zone génératrice de chaleur 124, 126 ou points chauds de la première carte à circuit imprimé 46 de puissance en fonctionnement. Chaque plot plein 136 est de forme cylindrique pleine agencée dans la pluralité d'ailettes de refroidissement 102. De préférence, les plots plein 136 sont surmoulé avec la pluralité d'ailettes de refroidissement 102.

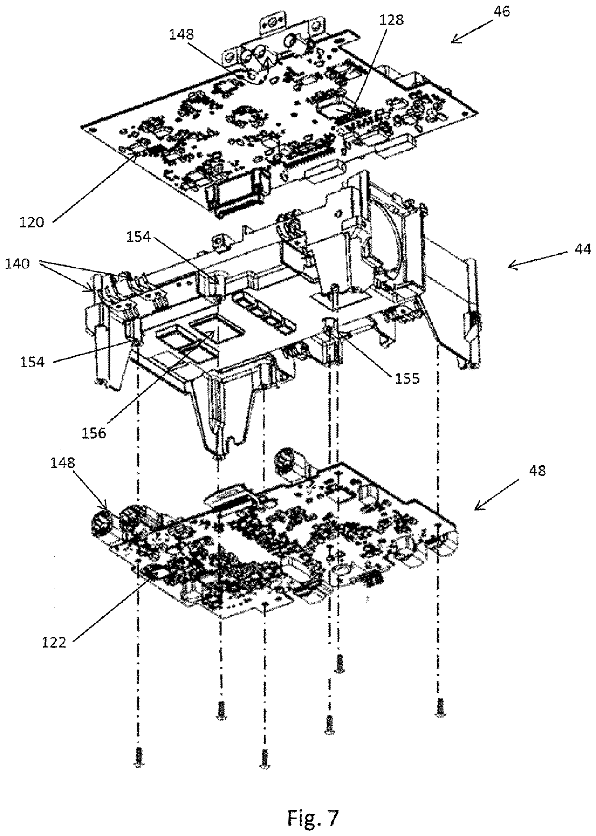

De façon additionnelle, une zone plane de refroidissement 138, globalement rectangulaire, est agencée transversalement sur quatre ailettes. La zone plane de refroidissement 138 permet également à une zone génératrice de chaleur 128 (figure 7) de la première carte à circuit imprimé 46, de venir en appui sur le dispositif de dissipation de chaleur 44. Les espaces inter ailettes 104 sous la zone plane de refroidissement 138 permettent le passage d'un flux d'air favorisant la dissipation thermique de la zone génératrice de chaleur 128 en appui sur la zone plane de refroidissement 138.

De préférence, les zones génératrices de chaleur 128 sont localisées sur la face de dessous de la première carte à circuit imprimé 46 et sont directement en contact par appui sur la zone plane de refroidissement 138 et/ ou directement en contact par appui avec les surfaces d'appui de l'extrémité libre des plots plein 136. Néanmoins, il est également possible de refroidir les zones génératrices de chaleur 124, 126 de la face de dessus de la première carte à circuit imprimé 46 lorsque ceux-ci sont en appui indirectement sur la zone plane de refroidissement 138 et/ ou indirectement en appui sur les surfaces d'appui de l'extrémité libre des plots plein 136; c'est-à-dire séparées de la zone plane de refroidissement 138 et/ ou des surfaces d'appui de l'extrémité libre des plots pleins 136 par l'épaisseur de la première carte à circuit imprimé 46.

La face supérieure de la seconde section 112 comporte un élément électrique de liaison 140 comprenant deux extrémités de contact flexibles 142, 144. L'élément de liaison électrique 140 comprend une partie intermédiaire 146 par laquelle l'élément de liaison est fixé sur le plateau 50, la partie intermédiaire étant prolongée d'un côté par la première extrémité flexible 142 suivant principalement une direction perpendiculaire au plateau 50, et de l'autre côté par la seconde extrémité flexible 144 suivant principalement une direction coplanaire au plateau 50.

La partie intermédiaire 146 comprend deux trous circulaires permettant le clipsage de l'élément de liaison électrique 140 dans deux ergots de fixation de la seconde section 112. Les ergots de fixation maintiennent la partie intermédiaire 146 au contact de la face supérieure de la seconde section 112. La partie intermédiaire 146 est prolongée d'un côté par la première extrémité flexible 142, et de l'autre côté par la seconde extrémité flexible 144.

Plus précisément, les deux ergots sont agencés sur la surface supérieure de l'extrémité libre d'un support métallique cylindrique de base globalement rectangulaire. Le support est de même hauteur verticale que le muret vertical arrière 78. La partie intermédiaire 146 vient au contact direct de la surface de l'extrémité libre du support métallique. L'élément de liaison électrique 140 est agencé dans les ergots de sorte à ce que la première extrémité 142 s'étend transversalement vers l'intérieur du dispositif de dissipation de chaleur 44 et verticalement vers le haut et en ce que la seconde extrémité 144 s'étend transversalement à l'extérieure du dispositif de dissipation de chaleur 44.

Alternativement, la partie intermédiaire 146 peut être fixé par soudure sur le plateau 50 ; dans ce cas, le plateau 50 ne comporte pas d'ergots et la partie intermédiaire ne comporte pas de trous.

En d'autres termes la première extrémité 142 et la seconde extrémité 144 s'étendent de part et d'autre du muret vertical arrière du plateau 78. A titre d'exemple non limitatif, chaque extrémité flexible comprend trois lames courbées de sorte à former à l'extrémité libre des trois lames une surface d'appui. Les trois lames de la seconde extrémité 144 de l'élément de liaison électrique 140 sont prévues pour être comprimées en appui entre le dispositif de dissipation de chaleur 44 et le boîtier de l'unité de contrôle. Plus précisément, chaque extrémité courbée des trois lames courbées de la seconde extrémité 144 est prévue pour venir au contact en appui sur la façade arrière du boîtier 18.

Les trois lames de la première extrémité 142 de l'élément de liaison électrique 140 sont prévues pour être comprimées entre le dispositif de dissipation de chaleur 44 et un connecteur de la première carte à circuit imprimé 46. Plus précisément, chaque extrémité courbée des trois lames courbées de la première extrémité 142 est prévue pour venir au contact en appui sur le corps métallique 148 d'un connecteur de type connecteur dédié aux communications hauts débits ou également d'un connecteur d'antenne ou de câble d'antenne radiofréquence.

L'élément électrique de liaison 140 permet la mise en contact, par écrasement de ses extrémités, d'un connecteur à corps métallique 148 de la première carte à circuit imprimé 46 au dispositif de dissipation de chaleur 44 ainsi qu'au boîtier 12 de l'unité de contrôle multimédia 10. Il peut s'agir, de préférence, d'un connecteur dédié aux communications hauts débits ou également d'un connecteur d'antenne ou de câble d'antenne radiofréquences.

La mise en contact par l'élément électrique de liaison 140 d'un connecteur avec le dispositif de dissipation de chaleur 44 et le boîtier permet une mise à la masse électrique locale dudit connecteur. Il faut comprendre que l'unité de contrôle multimédia 10 est prévue pour être fixée sur la carrosserie du véhicule, la carrosserie du véhicule servant de masse électrique. Le dispositif de dissipation de chaleur 44 a dans ce cas un rôle de protections contre les interférences électromagnétiques pouvant perturber les signaux transitant dans le dit connecteur et également de limiter le rayonnement électromagnétique du dit connecteur lors du transit de signaux hauts débits ou lors de transmissions de signaux radiofréquences.

Le muret vertical arrière 78 et le muret vertical avant 80 du plateau 50 comprennent chacun une ouverture circulaire 150, 152. Chaque ouverture circulaire 150, 152 est agencée au niveau de la surface supérieure de la seconde section 112 et de la troisième section 114. A titre d'exemple et de façon non limitative, chaque ouverture circulaire 150, 152 est agencée à l'extrémité gauche du muret vertical arrière 78 et avant 80. Ces ouvertures 150, 152 sont prévues pour évacuer de l'eau qui se serait formée par condensation sur la seconde et la troisième section. L'eau évacuée par ces ouvertures circulaires 150, 152 vient se loger dans le fond du boîtier, c'est-à-dire dans la façade inférieure 22. La façade inférieure 22 est équipée à chacun de ses quatre angles d'ouvertures permettant à l'eau de s'évacuer vers l'extérieur du boîtier.

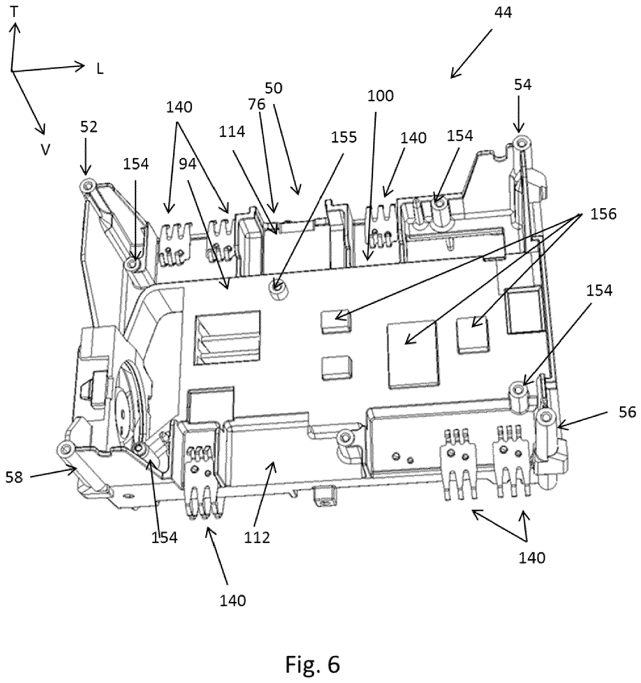

Selon la figure 6, le dispositif de dissipation de chaleur 44 est présenté retourné de sorte à visualiser la face inférieure 76 du plateau 50. On y distingue la face inférieure de la première section 94, de la seconde section 112 et de la troisième section 114. Selon la représentation, la face inférieure de la première section 94 est légèrement surélevée par rapport aux surfaces planes de la seconde et de la troisième section. La surface inférieure de la première section 94 forme la protubérance rectangulaire 100 sur la face inférieure du plateau 76.

La face inférieure de la seconde 112 et de la troisième 114 section sont globalement alignées selon un même plan horizontal.

Selon la figure 6 et la figure 7, la face inférieure du plateau 76 est adaptée pour recevoir la seconde carte à circuit imprimé 48. La face inférieure du plateau 76 est équipée de plusieurs plots de fixation 154, 155 pour la seconde carte à circuit imprimé 48. Les plots de fixation 154, 155 prévus pour la seconde carte à circuit imprimé 48 sont orientés verticalement vers le bas et permettent le maintien à plat, selon un plan horizontal, de la seconde carte à circuit imprimé 48. Tous les plots de fixations 154, 155 sont de forme cylindrique creuse, le creux étant un pas de vis. La seconde carte à circuit imprimé 48 est donc prévue pour être en appui par vissage contre la face inférieure protubérante de la première section du plateau 94.

Globalement, on notera particulièrement que quatre plots de fixations 154 sont globalement prévus pour maintenir la seconde carte à circuit imprimé 48 à proximité de ces quatre angles. Un autre plot de fixation 155 de la seconde carte à circuit imprimé 48 est agencé sur la face inférieure protubérante de la première section 94, de sorte à améliorer l'appui des zones génératrices de chaleur 130, 132 (figure 5) de la seconde carte à circuit imprimé 48 sur la première section 94.

Afin de servir de dispositif de dissipation de chaleur 44, la face inférieure de la première section 94 comporte des surfaces planes de refroidissement 156 globalement rectangulaires et légèrement surélevées par rapport à la surface de la première section 94 de sorte à former des protubérances sur la face inférieure de la première section 94. Ces surfaces planes de refroidissement 156 permettent à des zones génératrices de chaleur 130, 132 de la seconde carte à circuit imprimé 48, de venir en appui sur le dispositif de dissipation de chaleur 44.

De préférence, les zones génératrices de chaleur 130, 132 sont localisées sur la face de dessus de la seconde carte à circuit imprimé 48 et sont directement en contact par appui sur les surfaces planes de refroidissement 156. Néanmoins, il est également possible de refroidir des zones génératrices de chaleur de la face de dessous de la seconde carte à circuit imprimé 48 lorsque ceux-ci sont en appui indirectement sur les surfaces planes de refroidissement 156; c'est-à-dire séparées des surfaces planes de refroidissement 156 par l'épaisseur de la carte à circuit imprimé.

Selon le mode de réalisation représenté, le dispositif de dissipation de chaleur 44 est fait d'une seule pièce métallique. En d'autres termes, le plateau 50, la première section 94, la seconde section 112, la troisième section 114, la pluralité d'ailettes 102, le support de ventilateur 84, les piliers verticaux de fixation 52, 54, 56, 58 du dispositif de dissipation de chaleur 44 sur le fond de boîtier 22, les plots plein 136, les plots de fixation 135, 136, 154, 155, les surfaces de refroidissement 156, la zone plane de refroidissement 138 sont faits d'une seule pièce métallique. Seuls les éléments de liaison électriques 140, les vis et les cartes à circuit imprimés 46, 48 équipés de leurs composants électroniques et connecteurs sont des pièces supplémentaires rapportées sur le dispositif de dissipation de chaleur 44.

La face inférieure du plateau 76 comporte six éléments de liaison électrique 140 permettant la mise en contact, par écrasement de leur extrémité flexible, d'un connecteur à corps métallique 148 de la seconde carte à circuit imprimé 48 au dispositif de dissipation de chaleur 44 ainsi qu'au boîtier 12 de l'unité de contrôle multimédia 10. Ces six éléments de liaison électrique 140 sont identiques et ont la même fonction que celui décrit et monté sur la face supérieure du plateau 74.

De manière plus générale, les éléments de liaison électrique 140 peuvent être également utilisés pour mettre en contact un élément conducteur de la première carte à circuit imprimé 46 ou de la seconde carte à circuit imprimé 48 avec le plateau 50 et avec le boîtier 12 de sorte à protéger l'élément conducteur contre un échauffement thermique et contre les interférences électromagnétiques. Une piste de cuivre de masse électrique peut être un élément conducteur des cartes à circuit imprimé, comme également des corps métalliques de composants 148.

Selon les figures 3, 5 et 7, une méthode d'assemblage du module de contrôle multimédia 10 peut comprendre plusieurs étapes. Une première étape consiste à disposer de deux cartes à circuit imprimés 46, 48 comportant des zones génératrices de chaleur 124, 126, 128, 130, 132. Une seconde étape consiste à disposer d'un dispositif de dissipation de chaleur 44 tel que décrit précédemment au travers des figures 4 et 6. Une troisième étape consiste à disposer d'un boîtier 12 comprenant un fond de boîtier 22 et une façade avant 20. Une quatrième étape consiste à fixer la première carte à circuit imprimé 46 sur la face supérieure du plateau 74 afin de mettre en contact les zones génératrices de chaleur 124, 126, 128 de la première carte à circuit imprimé 46 sur la face supérieure du plateau 74. Une cinquième étape consiste à fixer la seconde carte à circuit imprimé 48 sur la face inférieure du plateau 76 afin de mettre en contact les zones génératrices de chaleur 130, 132 de la seconde carte à circuit imprimé 48 sur la face inférieure du plateau 76. Une sixième étape consiste à fixer les piliers de fixation 52, 54, 56, 58 du dispositif de dissipation de chaleur 44 équipé avec les deux cartes à circuit imprimé 46, 48 sur le fond de boîtier 22.

D'autres étapes d'assemblage peuvent améliorer la dissipation thermique et la protection aux interférences électromagnétiques de l'unité de contrôle multimédia 10. Une étape additionnelle peut consister à agencer des éléments de liaison électriques 140 comprenant des extrémités flexibles 142, 144 sur le plateau 50 de manière à mettre en contact, par compression des extrémités flexibles, des éléments conducteur 148 des cartes à circuit imprimé 46, 48 avec le plateau 50 et avec le boîtier 12. Une autre étape peut consister à fixer l'assemblage du plateau 50 avec les cartes à circuits imprimés 46, 48 sur une des façades du boîtier 14, 16, 18, 20. Une autre étape peut consister à fournir un boîtier 12 dont deux façades comprennent des ouvertures 32, 34 permettant la circulation d'un flux d'air dans l'unité de contrôle multimédia 10. Une étape peut consister à assembler un ventilateur 36 en vis-à-vis d'une façade 16 comprenant les ouvertures 34 afin de faciliter la circulation d'un flux d'air dans l'unité de contrôle multimédia 10.

## Revendications

1. Dispositif de dissipation de chaleur (44) comprenant
un plateau métallique de refroidissement (50) globalement rectangulaire;
le plateau métallique (50) comprenant sur sa face supérieure (74) des premiers moyens de fixation (134, 135) d'une première carte à circuit imprimé (46) prévus pour mettre en appui au moins une zone génératrice de chaleur (124) de la première carte à circuit imprimé (46) sur la face supérieure (74) du plateau (50);
le plateau métallique (50) comprenant sur sa face inférieure (76) des second moyens de fixations (154, 155) d'une seconde carte à circuit imprimé (48) prévus pour mettre en appui au moins une zone génératrice de chaleur (130) de la seconde carte à circuit imprimé (48) sur la face inférieure (76) du plateau (50) ;
la face supérieure (74) du plateau (50) comprenant une première section (94) équipée d'une pluralité d'ailettes verticales de refroidissement (102) s'étendant chacune selon une direction longitudinal sensiblement parallèle à un côté du plateau (50);
**caractérisé en ce que**
la première section (94) comprend une partie des premiers moyens de fixation (135) de sorte à permettre l'appui d'une zone génératrice de chaleur (124) de la première carte à circuit imprimé (46) sur des ailettes de refroidissement (102), et **en ce que**
la face inférieure de la première section (94) comprend au moins une surface plane de refroidissement (156) formant une protubérance sur la dite face inférieure, de sorte à permettre l'appui d'une zone génératrice de chaleur (130) de la seconde carte à circuit imprimé (48) sur la surface plane de refroidissement (156).

2. Dispositif de dissipation de chaleur (44) selon la revendication 1, **caractérisé en ce que** la première section (94) comprend une zone plane de refroidissement (138) s'étendant transversalement sur le haut d'au moins deux ailettes (102) de sorte à permettre l'appui d'une zone génératrice de chaleur (124) de la première carte à circuit imprimé (46) sur la zone plane de refroidissement (138).

3. Dispositif de dissipation de chaleur (44) selon l'une quelconque des revendications précédentes **caractérisé en ce que** la première section (94) comprend au moins un plot cylindrique plein vertical (136) surmoulé dans une ailette de refroidissement (102) de sorte à permettre l'appui d'une zone génératrice de chaleur (124) de la première carte à circuit imprimé (46) sur l'extrémité libre du plot cylindrique plein (136).

4. Dispositif de dissipation de chaleur (44) selon l'une quelconque des revendications précédentes **caractérisé en ce que** la première section (94) forme un renfoncement rectangulaire dans la face supérieure (74) du plateau (50), formant une protubérance (100) rectangulaire sur la face inférieure (76) du plateau (50).

5. Dispositif de dissipation de chaleur (44) selon l'une quelconque des revendication précédentes **caractérisé en ce que** la face inférieure de la première section (96) comprend une partie des seconds moyens de fixation (155) de sorte à permettre l'appui d'au moins une zone génératrice de chaleur (130) de la seconde carte à circuit imprimé (48) sur la face inférieure de la première section (94).

6. Dispositif de dissipation de chaleur (44) selon l'une quelconque des revendications précédentes **caractérisé en ce que**
le plateau (50) comporte au moins trois piliers métalliques (52, 54, 56) s'étendant verticalement vers le bas depuis la face inférieure (76) du plateau (50);
l'extrémité basse de chaque pilier (52, 54, 56) est munie d'un moyen de fixation (60, 62, 64, 66) prévu pour être fixé sur un fond de boîtier (22) de sorte à maintenir le plateau (50) surélevé pour agencer la seconde carte à circuit imprimé (48) sur la face inférieure (76) du plateau (50).

7. Dispositif de dissipation de chaleur (44) selon l'une quelconque des revendications précédentes **caractérisé en ce qu'**un côté transversal du plateau (50) comporte un support de ventilateur (84) apte à recevoir un ventilateur (36) permettant de créer un flux d'air de refroidissement du plateau (50) suivant une direction longitudinale.

8. Dispositif de dissipation de chaleur (44) selon la revendication 7 **caractérisé en ce que** le plateau (50) comporte des déflecteurs (106, 108) agencés entre le support de ventilateur (84) et la première section (94) apte à guider le flux d'air de refroidissement.

9. Dispositif de dissipation de chaleur (44) selon la revendication 7 ou 8, **caractérisé en ce que**
le plateau (50) comporte une ouverture (110) entre la première section (94) et le support de ventilateur (84), de sorte à favoriser un flux d'air sur les deux faces (74, 76) du plateau (50).

10. Dispositif de dissipation de chaleur (44) selon l'une quelconque des revendications précédentes, **caractérisé en ce que**
le plateau (50) comprend un élément de liaison électrique (140) comprenant deux extrémités de contact flexibles (142, 144);
la première extrémité (142) étant prévue pour établir un contact électrique par compression entre le plateau de refroidissement (50) et un élément électriquement conducteur (148) de la première carte à circuit imprimé (46) ou de la seconde carte à circuit imprimé (48);
la seconde extrémité (144) étant prévue pour établir un contact électrique par compression entre le plateau (50) et un boîtier métallique (12) enfermant le dispositif de dissipation de chaleur (44);
de sorte à protéger thermiquement et électromagnétiquement l'élément électriquement conducteur (148).

11. Dispositif de dissipation de chaleur (44) selon la revendication 10 **caractérisé en ce que** l'élément de liaison électrique (140) comprend une partie intermédiaire (146) par laquelle l'élément de liaison (140) est fixé sur le plateau (50), la partie intermédiaire (146) étant prolongée d'un côté par la première extrémité flexible (142) suivant principalement une direction perpendiculaire au plateau (50), et de l'autre côté par la seconde extrémité flexible (144) suivant principalement une direction coplanaire au plateau (50).

12. Dispositif de dissipation de chaleur (44) selon l'une quelconque des revendications 1 à 9 **caractérisé en ce que** le dispositif de dissipation de chaleur (44) est fait d'une seule pièce métallique.

13. Assemblage électronique comportant un dispositif de dissipation de chaleur (44) selon l'une quelconque des revendications précédentes ; l'assemblage électronique comprenant :
une première carte à circuit imprimé (46) comportant une zone génératrice de chaleur (124) en appui sur la face supérieure (74) du plateau de refroidissement (50);
une seconde carte à circuit imprimé (48) comportant une zone génératrice de chaleur (130) en appui sur la face inférieure (76) du plateau de refroidissement (50).

14. Assemblage électronique selon la revendication 13 et la revendication 6 **caractérisé en ce qu'**il comporte un boîtier métallique (12) fermé de forme globalement parallélépipédique rectangle ;
le dispositif de dissipation de chaleur (44) étant fixé dans le fond du boîtier (22).

15. Assemblage électronique selon la revendication 14 **caractérisé en ce que** le boîtier (12) comprend
un premier groupe d'ouvertures (32) agencé sur une première face latérale (14) du boîtier (12) et en vis-à-vis du plateau de refroidissement (50) ;
un second groupe d'ouvertures (34) agencé sur une seconde face latérale (16) du boîtier (12) opposée à la première face (14) et en vis-à-vis du plateau de refroidissement (50);
de sorte à permettre la circulation d'un flux d'air de refroidissement depuis le premier groupe d'ouvertures (32) jusqu'au second groupe d'ouvertures (34).

16. Assemblage électronique selon la revendication 15 et la revendication 7 **caractérisé en ce qu'**un ventilateur (36) est monté dans le support de ventilateur (84) et est agencé dans le boîtier (12) en vis-à-vis de l'un des deux groupes d'ouverture (32, 34) de sorte à faciliter la circulation du flux d'air de refroidissement.

17. Assemblage électronique selon l'une quelconque des revendications 14 à 16 et l'une quelconque des revendications 10 à 11 **caractérisé en ce que**
le plateau (50) comporte un élément de liaison électrique (140) ;
au moins une des cartes à circuit imprimé (46, 48) comprend un élément conducteur (148) ;
l'élément conducteur (148) étant en contact électrique par l'élément de liaison électrique (140) avec le plateau (50) et le boîtier métallique (12) de sorte à protéger thermiquement et électromagnétiquement l'élément conducteur (148).

## Patentansprüche

1. Wärmeableitungsvorrichtung (44), umfassend
eine allgemein rechteckige metallische Kühlplatte (50);
wobei die Metallplatte (50) auf ihrer oberen Fläche (74) erste Befestigungsmittel (134, 135) einer ersten gedruckten Leiterplatte (46) umfasst, die vorgesehen sind, um mindestens eine wärmeerzeugende Zone (124) der ersten gedruckten Leiterplatte (46) auf der oberen Fläche (74) der Platte (50) in Abstützung zu bringen;
wobei die Metallplatte (50) auf ihrer unteren Fläche (76) zweite Befestigungsmittel (154, 155) einer zweiten gedruckten Leiterplatte (48) umfasst, die vorgesehen sind, um mindestens eine wärmeerzeugende Zone (130) der zweiten gedruckten Leiterplatte (48) auf der unteren Fläche (76) der Platte (50) in Abstützung zu bringen;
wobei die obere Fläche (74) der Platte (50) einen ersten Abschnitt (94) umfasst, der mit einer Vielzahl vertikaler Kühlflügel (102) ausgestattet ist, die sich jeweils in einer Längsrichtung etwa parallel zu einer Seite der Platte (50) erstrecken;
**dadurch gekennzeichnet, dass**
der erste Abschnitt (94) einen Teil der ersten Befestigungsmittel (135) umfasst, so dass die Abstützung einer wärmeerzeugenden Zone (124) der ersten gedruckten Leiterplatte (46) auf den Kühlflügeln (102) gestattet ist, und dass
die untere Fläche des ersten Abschnitts (94) mindestens eine ebene Kühloberfläche (156) umfasst, die einen Vorsprung auf der unteren Fläche bildet, so dass die Abstützung einer wärmeerzeugenden Zone (130) der zweiten gedruckten Leiterplatte (48) auf der ebenen Kühloberfläche (156) gestattet ist.

2. Wärmeableitungsvorrichtung (44) nach Anspruch 1, **dadurch gekennzeichnet, dass** der erste Abschnitt (94) eine ebene Kühlzone (138) umfasst, die sich quer auf der Höhe von mindestens zwei Flügeln (102) erstreckt, so dass die Abstützung einer wärmeerzeugenden Zone (124) der ersten gedruckten Leiterplatte (46) auf der ebenen Kühlzone (138) gestattet ist.

3. Wärmeableitungsvorrichtung (44) nach einem der vorangehenden Ansprüche, **dadurch gekennzeichnet, dass** der erste Abschnitt (94) mindestens einen überformten vertikalen vollen zylindrischen Stift (136) in einem Kühlflügel (102) umfasst, so dass die Abstützung einer wärmeerzeugenden Zone (124) der ersten gedruckten Leiterplatte (46) auf dem freien Ende des vollen zylindrischen Stifts (136) gestattet ist.

4. Wärmeableitungsvorrichtung (44) nach einem der vorangehenden Ansprüche, **dadurch gekennzeichnet, dass** der erste Abschnitt (94) eine rechteckige Vertiefung in der oberen Fläche (74) der Platte (50) bildet, die einen rechteckigen Vorsprung (100) auf der unteren Fläche (76) der Platte (50) bildet.

5. Wärmeableitungsvorrichtung (44) nach einem der vorangehenden Ansprüche, **dadurch gekennzeichnet, dass** die untere Fläche des ersten Abschnitts (96) einen Teil der zweiten Befestigungsmittel (155) umfasst, so dass die Abstützung mindestens einer wärmeerzeugenden Zone (130) der zweiten gedruckten Leiterplatte (48) auf der unteren Fläche des ersten Abschnitts (94) gestattet ist.

6. Wärmeableitungsvorrichtung (44) nach einem der vorangehenden Ansprüche, **dadurch gekennzeichnet, dass**
die Platte (50) mindestens drei Metallpfeiler (52, 54, 56) aufweist, die sich vertikal nach unten ab der unteren Fläche (76) der Platte (50) erstrecken;
das untere Ende jedes Pfeilers (52, 54, 56) mit einem Befestigungsmittel (60, 62, 64, 66) versehen ist, das vorgesehen ist, um auf einem Gehäuseboden (22) befestigt zu sein, so dass die Platte (50) erhöht gehalten wird, um die zweite gedruckte Leiterplatte (48) auf der unteren Fläche (76) der Platte (50) anzuordnen.

7. Wärmeableitungsvorrichtung (44) nach einem der vorangehenden Ansprüche, **dadurch gekennzeichnet, dass** eine transversale Seite der Platte (50) einen Ventilatorhalter (84) aufweist, der imstande ist, einen Ventilator (36) aufzunehmen, der erlaubt, einen Kühlluftstrom der Platte (50) gemäß einer Längsrichtung zu erzeugen.

8. Wärmeableitungsvorrichtung (44) nach Anspruch 7, **dadurch gekennzeichnet, dass** die Platte (50) Ablenker (106, 108) aufweist, die zwischen dem Ventilatorhalter (84) und dem ersten Abschnitt (94) eingerichtet sind, die imstande sind, den Kühlluftstrom zu lenken.

9. Wärmeableitungsvorrichtung (44) nach Anspruch 7 oder 8, **dadurch gekennzeichnet, dass**
die Platte (50) eine Öffnung (110) zwischen dem ersten Abschnitt (94) und dem Ventilatorhalter (84) aufweist, so dass ein Luftstrom auf den zwei Flächen (74, 76) der Platte (50) begünstigt wird.

10. Wärmeableitungsvorrichtung (44) nach einem der vorangehenden Ansprüche, **dadurch gekennzeichnet, dass**
die Platte (50) ein elektrisches Verbindungselement (140) umfasst, das zwei flexible Kontaktenden (142, 144) umfasst;
wobei das erste Ende (142) vorgesehen ist, um einen elektrischen Kontakt durch Kompression zwischen der Kühlplatte (50) und einem elektrisch leitenden Element (148) der ersten gedruckten Leiterplatte (46) oder der zweiten gedruckten Leiterplatte (48) herzustellen;
wobei das zweite Ende (144) vorgesehen ist, um einen elektrischen Kontakt durch Kompression zwischen der Platte (50) und einem Metallkasten (12) herzustellen, der die Wärmeableitungsvorrichtung (44) einschließt;
so dass das elektrisch leitende Element (148) thermisch und elektromagnetisch geschützt wird.

11. Wärmeableitungsvorrichtung (44) nach Anspruch 10, **dadurch gekennzeichnet, dass** das elektrische Verbindungselement (140) einen Übergangsteil (146) umfasst, mit dem das Verbindungselement (140) auf der Platte (50) befestigt ist, wobei der Übergangsteil (146) auf der einen Seite vom ersten flexiblen Ende (142) in hauptsächlich einer zur Platte (50) senkrechten Richtung und auf der anderen Seite vom zweiten flexiblen Ende (144) in hauptsächlich einer zur Platte (50) koplanaren Richtung verlängert wird.

12. Wärmeableitungsvorrichtung (44) nach einem der Ansprüche 1 bis 9, **dadurch gekennzeichnet, dass** die Wärmeableitungsvorrichtung (44) aus einem einzigen Metallteil besteht.

13. Elektronische Montage, die eine Wärmeableitungsvorrichtung (44) nach einem der vorangehenden Ansprüche aufweist; wobei die elektronische Montage umfasst:
eine erste gedruckte Leiterplatte (46), die eine wärmeerzeugende Zone (124) in Abstützung auf der oberen Fläche (74) der Kühlplatte (50) aufweist;
eine zweite gedruckte Leiterplatte (48), die eine wärmeerzeugende Zone (130) in Abstützung auf der unteren Fläche (76) der Kühlplatte (50) aufweist.

14. Elektronische Montage nach Anspruch 13 und Anspruch 6, **dadurch gekennzeichnet, dass** sie einen global rechteckigen parallelepipedischen geschlossenen Metallkasten (12) aufweist;
wobei die Wärmeableitungsvorrichtung (44) im Boden des Kastens (22) befestigt ist.

15. Elektronische Montage nach Anspruch 14, **dadurch gekennzeichnet, dass** der Kasten (12) umfasst
eine erste Gruppe von Öffnungen (32), die auf einer ersten Seitenfläche (14) des Kastens (12) und gegenüber der Kühlplatte (50) eingerichtet ist;
eine zweite Gruppe von Öffnungen (34), die auf einer zweiten Seitenfläche (16) des Kastens (12) entgegengesetzt zur ersten Fläche (14) und gegenüber der Kühlplatte (50) eingerichtet ist;
so dass die Zirkulation eines Kühlluftstroms ab der ersten Gruppe von Öffnungen (32) bis zur zweiten Gruppe von Öffnungen (34) gestattet ist.

16. Elektronische Montage nach Anspruch 15 und Anspruch 7, **dadurch gekennzeichnet, dass** ein Ventilator (36) im Ventilatorhalter (84) angebracht und im Kasten (12) gegenüber von einer der zwei Gruppen von Öffnungen (32, 34) eingerichtet ist, so dass die Zirkulation eines Kühlluftstroms erleichtert wird.

17. Elektronische Montage nach einem der Ansprüche 14 bis 16 und einem der Ansprüche 10 bis 11, **dadurch gekennzeichnet, dass**
die Platte (50) ein elektrisches Verbindungselement (140) aufweist;
mindestens eine der gedruckten Leiterplatten (46, 48) ein leitendes Element (148) umfasst;
wobei das leitende Element (148) durch das elektrische Verbindungselement (140) in elektrischem Kontakt mit der Platte (50) und dem Metallkasten (12) ist, so dass das leitende Element (148) thermisch und elektromagnetisch geschützt wird.

## Claims

1. A heat dissipation device (44) comprising:
a generally rectangular cooling metal plate (50);
the metal plate (50) comprising, on its upper face (74), first fastening means (134, 135) for fastening a first printed circuit board (46) provided to abut at least one heat generating area (124) of the first printed circuit board (46) on the upper face (74) of the plate (50),
the metal plate (50) comprising, on its lower face (76), second fastening means (154, 155) for fastening a second printed circuit board (48) provided to abut at least one heat generating area (130) of the second printed circuit board (48) on the lower face (76) of the plate (50);
the upper face (74) of the plate (50) comprising a first section (94) equipped with a plurality of vertical cooling fins (102) each extending in a longitudinal direction substantially parallel to one side of the plate (50);
**characterized in that**:
the first section (94) comprises a portion of the first fastening means (135) so as to allow the abutment of a heat generating area (124) of the first printed circuit board (46) on cooling fins (102), and **in that**:
the lower face of the first section (94) comprises at least one flat cooling surface (156) forming a protrusion on said lower face, so as to allow the abutment of a heat generating area (130) of the second printed circuit board (48) on the flat cooling surface (156).

2. The heat dissipation device (44) according to claim 1, **characterized in that** the first section (94) comprises a flat cooling area (138) extending transversely on the top of at least two fins (102) so as to allow the abutment of a heat generating area (124) of the first printed circuit board (46) on the flat cooling area (138).

3. The heat dissipation device (44) according to any one of the preceding claims, **characterized in that** the first section (94) comprises at least one vertical solid cylindrical stud (136) over-molded in a cooling fin (102) so as to allow the abutment of a heat generating area (124) of the first printed circuit board (46) on the free end of the solid cylindrical stud (136) .

4. The heat dissipation device (44) according to any one of the preceding claims, **characterized in that** the first section (94) forms a rectangular recess in the upper face (74) of the plate (50), forming a rectangular protrusion (100) on the lower face (76) of the plate (50).

5. The heat dissipation device (44) according to any one of the preceding claims, **characterized in that** the lower face of the first section (96) comprises a portion of the second fastening means (155) so as to allow the abutment of at least one heat generating area (130) of the second printed circuit board (48) on the lower face of the first section (94).

6. The heat dissipation device (44) according to any one of the preceding claims, **characterized in that**:
the plate (50) includes at least three metal pillars (52, 54, 56) extending vertically downwards from the lower face (76) of the plate (50);
the low end of each pillar (52, 54, 56) is equipped with a fastening means (60, 62, 64, 66) provided to be fastened on a casing bottom (22) so as to hold the plate (50) raised to arrange the second printed circuit board (48) on the lower face (76) of the plate (50).

7. The heat dissipation device (44) according to any one of the preceding claims, **characterized in that** a transverse side of the plate (50) includes a fan holder (84) able to receive a fan (36) for creating a cooling air flow of the plate (50) in a longitudinal direction.

8. The heat dissipation device (44) according to claim 7, **characterized in that** the plate (50) includes deflectors (106, 108) arranged between the fan holder (84) and the first section (94) able to guide the cooling air flow.

9. The heat dissipation device (44) according to claim 7 or 8, **characterized in that**:
the plate (50) includes an opening (110) between the first section (94) and the fan holder (84), so as to promote an air flow on both faces (74, 76) of the plate (50).

10. The heat dissipation device (44) according to any one of the preceding claims, **characterized in that**:
the plate (50) comprises an electrical connection element (140) comprising two flexible contact ends (142, 144);
the first end (142) being provided to establish electrical contact by compression between the cooling plate (50) and an electrically conductive element (148) of the first printed circuit board (46) or the second printed circuit board (48);
the second end (144) being provided to establish electrical contact by compression between the plate (50) and a metal casing (12) enclosing the heat dissipation device (44);
so as to thermally and electromagnetically protect the electrically conductive element (148).

11. The heat dissipation device (44) according to claim 10, **characterized in that** the electrical connection element (140) comprises an intermediate portion (146) by which the connection element (140) is fastened on the plate (50), the intermediate portion (146) being extended, on one side, by the first flexible end (142) mainly in a direction perpendicular to the plate (50) and, on the other side, by the second flexible end (144) mainly in a direction coplanar with the plate (50).

12. The heat dissipation device (44) according to any one of claims 1 to 9, **characterized in that** the heat dissipation device (44) is made in a single metal piece.

13. An electronic assembly comprising a heat dissipation device (44) according to any one of the preceding claims; the electronic assembly comprising:
a first printed circuit board (46) including a heat generating area (124) in abutment on the upper face (74) of the cooling plate (50);
a second printed circuit board (48) including a heat generating area (130) in abutment on the lower face (76) of the cooling plate (50).

14. The electronic assembly according to claim 13 and claim 6, **characterized in that** it comprises a closed metal casing (12) of generally parallelepiped rectangular shape;
the heat dissipation device (44) being fastened in the bottom of the casing (22).

15. The electronic assembly according to claim 14, **characterized in that** the casing (12) comprises:
a first group of openings (32) arranged on a first lateral face (14) of the casing (12) and facing the cooling plate (50);
a second group of openings (34) arranged on a second lateral face (16) of the casing (12) opposite the first face (14) and facing the cooling plate (50);
so as to allow the circulation of a cooling air flow from the first group of openings (32) to the second group of openings (34) .

16. The electronic assembly according to claim 15 and claim 7, **characterized in that** a fan (36) is mounted in the fan holder (84) and is arranged in the casing (12) facing one of the two opening groups (32, 34) so as to facilitate the circulation of the cooling air flow.

17. The electronic assembly according to any one of claims 14 to 16 and any one of claims 10 to 11, **characterized in that**:
the plate (50) includes an electrical connection element (140) ;
at least one of the printed circuit boards (46, 48) comprises a conductive element (148);
the conductive element (148) being in electrical contact, by the electrical connection element (140) with the plate (50) and the metal casing (12) so as to thermally and electromagnetically protect the conductive element (148).
